(19) Europäisches Patentamt European Patent Office Office européen des brevets

(11) **EP 4 451 531 A1**

(12) **EUROPEAN PATENT APPLICATION**

(43) Date of publication:
**23.10.2024 Bulletin 2024/43**

(21) Application number: **24166523.1**

(22) Date of filing: **26.03.2024**

(51) International Patent Classification (IPC):
**H02M 1/00** *(2006.01)*　　**H02M 3/158** *(2006.01)*

(52) Cooperative Patent Classification (CPC):
**H02M 1/0009;** H02M 1/0025; H02M 3/158

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **19.04.2023 KR 20230051547**

(71) Applicant: **Samsung Electronics Co., Ltd.**
**Suwon-si, Gyeonggi-do 16677 (KR)**

(72) Inventors:
• **YUN, Dam**
  **16677 Suwon-si (KR)**
• **PARK, Jaehyun**
  **16677 Suwon-si (KR)**
• **YOON, Jehyung**
  **16677 Suwon-si (KR)**
• **CHO, Sangik**
  **16677 Suwon-si (KR)**

(74) Representative: **Marks & Clerk LLP**
**15 Fetter Lane**
**London EC4A 1BW (GB)**

(54) **BI-DIRECTIONAL CURRENT SENSOR, POWER MANAGEMENT INTEGRATED CIRCUIT AND CURRENT SENSING METHOD THEREOF**

(57) A bi-directional direct current to direct current (DC-DC) converter includes: an inductor; a first switching transistor configured to switch a power supply voltage to one end of the inductor, in response to a first driving signal; a second switching transistor configured to switch between one end of the inductor and a ground voltage, in response to a second driving signal; and a bi-directional current sensor configured to sense a bi-directional current flowing through the second switching transistor in a boost mode and a buck mode, based on a switching node voltage at a drain of the second switching transistor, wherein the bi-directional current sensor is further configured to generate a virtual voltage of a positive voltage in a negative feedback method regardless of the sign of the switching node voltage to copy the bi-directional current.

FIG. 2

**Description**

BACKGROUND

1. Field

The disclosure relates to a semiconductor device, and more particularly, to a bi-directional current sensor, a power management integrated circuit, and a current sensing method thereof.

2. Description of Related Art

Recently, demand for storage for providing various data services (such as data centers or servers or artificial intelligence (AI) services) is rapidly increasing. In particular, a solid state drive (SSD) using a flash memory device is widely used as a storage device. The storage device may include a storage controller, a buffer, and a flash memory. The storage device may operate by receiving power from the outside. While the storage device is operating, a sudden power-off (SPO) situation (in which power is suddenly cut off) may occur. When the SPO situation occurs, data stored in the buffer may be lost, or an operation being performed in the flash memory may not be completed. In order to solve this problem, the storage device uses an auxiliary power supply (e.g., capacitor) to complete an operation in progress and back up data when the SPO situation occurs.

A power loss protection (PLP) integrated circuit (IC) is used as a device that charges an auxiliary power supply in the SSD. The PLP IC supports a backup operation by utilizing the charged auxiliary power supply when an SPO occurs. The PLP IC uses a bi-directional direct current to direct current (DC-DC) converter to boost the input voltage in normal mode and supply the boosted input voltage to the power management integrated circuit (PMIC) or charge the auxiliary power supply.

On the other hand, when an SPO occurs, the PLP IC operates in a buck mode in which the input voltage is cut off and backup power is supplied to the storage device using the power charged in the auxiliary power supply. Bi-directional DC-DC converters can suffer losses due to overcurrent during operation. To prevent the overcurrent issue, an overcurrent prevention function may be used, and a bi-directional current sensor is required for this purpose.

SUMMARY

Provided are a bi-directional current sensor capable of providing high noise filtering performance in a high voltage environment and a power loss protection (PLP) integrated circuit (IC) including the same.

According to one aspect of the disclosure, a bi-directional direct current to direct current (DC-DC) converter includes: an inductor; a first switching transistor configured to switch a power supply voltage to one end of the inductor, in response to a first driving signal; a second switching transistor configured to switch between one end of the inductor and a ground voltage, in response to a second driving signal; and a bi-directional current sensor configured to sense a bi-directional current flowing through the second switching transistor in a boost mode and a buck mode, based on a switching node voltage at a drain of the second switching transistor, wherein the bi-directional current sensor is further configured to generate a virtual voltage of a positive voltage in a negative feedback method regardless of the sign of the switching node voltage to copy the bi-directional current.

According to another aspect of the disclosure, a bi-directional current sensor for sensing a current flowing in a switching transistor of a direct current to direct current (DC-DC) converter, includes: a voltage clamp circuit configured to clamp a switching node voltage at one end of the switching transistor to a clamp voltage; a first amplifier configured to generate a first amplified voltage by amplifying a differential voltage between a clamp voltage and a ground voltage; a polarity selector circuit configured to convert a polarity of the first amplified voltage into a positive voltage, based on a mode; a second amplifier configured to amplify a differential voltage between a virtual voltage and the ground voltage and to generate a second amplified voltage; a subtractor circuit configured to generate an amplified voltage by subtracting the second amplified voltage from the first amplified voltage; a source follower transistor configured to transfer the amplified voltage to the virtual voltage; and a sensing transistor configured to transfer a sensing current corresponding to the virtual voltage to a ground.

According to another aspect of the disclosure, a current sensing method of a switching transistor of a bi-directional DC-DC converter, includes: generating a clamp voltage by clamping a switching node voltage at one end of the switching transistor; generating a first amplified voltage by amplifying a differential voltage between the clamp voltage and a ground voltage using a first amplifier; generating a second amplified voltage by amplifying a differential voltage between a virtual voltage and the ground voltage using a second amplifier; generating an amplified voltage by subtracting the second amplified voltage from the first amplified voltage; transferring the amplified voltage as the virtual voltage to a sensing transistor through a source follower; and detecting a sensing current flowing through the sensing transistor by the virtual voltage.

At least some of the above and other features of the invention are set out in the claims.

BRIEF DESCRIPTION OF DRAWINGS

The above and other objects and features of the present disclosure will become apparent by describing in detail embodiments thereof with reference to the accompanying drawings, in which:

FIG. 1 illustrates a storage device including a bi-directional current sensor according to an embodiment of the disclosure;

FIG. 2 illustrates a configuration of a bi-directional direct current to direct current (DC-DC) converter of the disclosure;

FIG. 3 illustrates an example structure of the bi-directional current sensor of the disclosure shown in FIG. 2;

FIG. 4 illustrates example structures of a first amplifier, a second amplifier, and an adder of FIG. 3;

FIG. 5 illustrates a current sensing operation of a bi-directional current sensor in a boost mode;

FIG. 6 illustrates an operation of the bi-directional current sensor of FIG. 5;

FIG. 7 illustrates waveforms of FIG. 6 in more detail;

FIG. 8 illustrates a current sensing operation of a bi-directional current sensor in buck mode;

FIG. 9 illustrates an operation of the bi-directional current sensor of FIG. 8;

FIG. 10 illustrates waveforms of FIG. 9 in more detail;

FIG. 11 illustrates a common mode gain of the bi-directional current sensor of the disclosure; and

FIG. 12 illustrates transient response characteristics of the bi-directional current sensor of the disclosure.

DETAILED DESCRIPTION

Hereinafter, embodiments of the disclosure will be described with reference to the accompanying drawings in order to describe in detail enough for those skilled in the art to easily implement the technical idea of the disclosure.

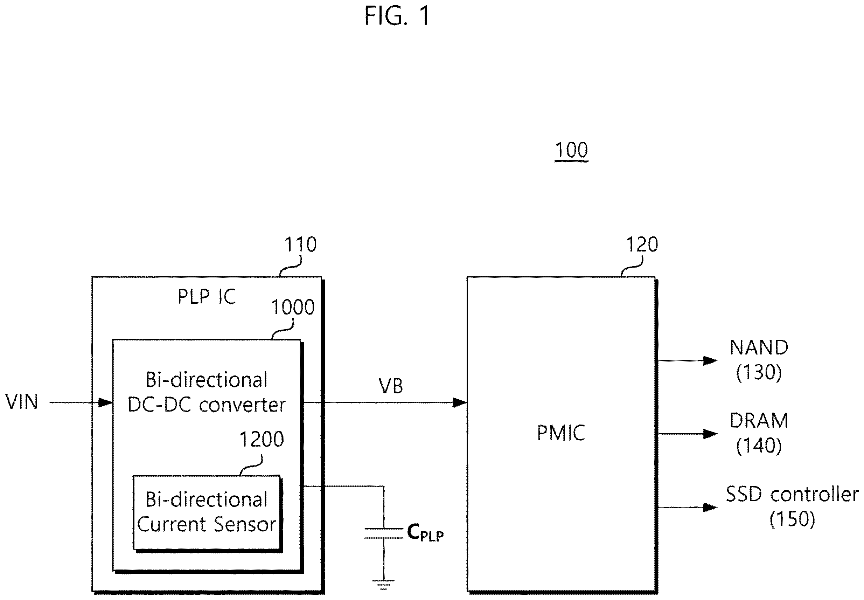

FIG. 1 is a block diagram illustrating a storage device including a bi-directional current sensor according to an embodiment of the disclosure. Referring to FIG. 1, a storage device 100 according to the disclosure may include a power loss protection (PLP) integrated circuit (IC) 110 and a power management integrated circuit (PMIC) 120. The storage device 100 may be, for example, a solid state drive SSD.

The PLP IC 110 includes a bi-directional direct current to direct current (DC-DC) converter 1000 including the bi-directional current sensor 1200 of the disclosure. The bi-directional DC-DC converter 1000 may boost the voltage VIN input from the outside and provide the boosted voltage as the power supply voltage VB of the PMIC 120 or charge the capacitor $C_{PLP}$ to be used as an auxiliary power supply. For example, the input voltage VIN may be a DC voltage of 12V, and the power supply voltage VB may be a DC voltage of 30V. That is, during a normal operation, the bi-directional DC-DC converter 1000 operates in a boost mode in which the input voltage VIN is boosted and provided as the power supply voltage VB.

On the other hand, when sudden power off or power failure occurs, the bi-directional DC-DC converter 1000 operates in a buck mode. That is, the bi-directional DC-DC converter 1000 drops the voltage of the charged capacitor $C_{PLP}$ and uses the voltage as backup power for the storage device 100. For example, the bi-directional DC-DC converter 1000 may process the voltage of the capacitor $C_{PLP}$ in the buck mode and supply the voltage as the power supply voltage VB of the PMIC 120. Then, the storage device 100 may back up data stored in the buffer or flash memory using the backup power (the voltage) provided from the capacitor $C_{PLP}$.

The bi-directional current sensor 1200 is configured to sense an amount of current in the boost mode and the buck mode of the bi-directional DC-DC converter 1000. That is, the bi-directional current sensor 1200 is configured to sense the current of a (ground-side) power transistor that switches the inductor current in the bi-directional DC-DC converter 1000. The current flowing through the (ground-side) power transistor flows to the ground side in the boost mode and in the opposite direction (from the ground side) in the buck mode. The bi-directional current sensor 1200 may sense the magnitude of the current flowing through the (ground-side) power transistor regardless of the direction of the current.

The bi-directional current sensor 1200 may be configured to sense the current of the (ground-side) power transistor of the bi-directional DC-DC converter 1000 in both the boost mode and the buck mode. According to the result sensed by the bi-directional current sensor 1200, the DC-DC converter 1000 may identify and block overcurrent. Sensing elements and current copy elements may be separated by the bi-directional current sensor 1200 of the disclosure. That is, since the sensing transistor may be connected to the first ground AVSS, a high common mode rejection ratio CMRR can be secured. That is, the bi-directional current sensor 1200 of the disclosure may have excellent noise canceling performance against interference or noise flowing into the second ground PVSS of adjacent channels. Here, the first ground AVSS is a ground terminal for a small signal or small capacity, and the second ground PVSS is a ground terminal for a large signal or large capacity. Accordingly, the first ground AVSS has little noise, while the second ground PVSS has relatively large noise.

The PMIC 120 may receive power from the PLP IC 110. For example, the PMIC 120 may convert a voltage provided from the PLP IC 110 into a stable voltage. The PMIC 120 may provide a stable voltage to components of the solid state drive (SSD). For example, the PMIC 120 may supply a stabilized voltage to the NAND flash memory 130 used as a storage medium, the dynamic random access memory (DRAM) 140 used as a buffer, and the SSD controller 150. The PMIC 120 uses a power supply voltage VB obtained by boosting the input voltage VIN in the boost mode of the bi-directional DC-DC converter 1000. On the other hand, the PMIC 120 uses the voltage provided from the charged capacitor $C_{PLP}$ as the power supply voltage VB in the buck mode of the bi-directional DC-DC converter 1000.

As an example, each of the PLP IC 110 or PMIC 120 may be implemented as an integrated circuit chip. Each of the PLP IC 110 or the PMIC 120 may be mounted using various types of semiconductor packages. For example, each of the PLP IC 110 or the PMIC 120 may include a package on package (PoP), ball grid arrays (BGAs), chip scale packages (CSPs), a plastic leaded chip carrier (PLCC), and a plastic dual in (PDIP). -line Package), Die in Waffle Pack, Die in Wafer Form, COB (Chip On Board), CERDIP (Ceramic Dual In-line Package), MQFP (Metric Quad Flat Pack), TQFP (Thin Quad Flat Pack), SOIC (Small Outline Integrated Circuit), Shrink Small Outline Package (SSOP), Thin Small Outline Package (TSOP), System In Package (SIP), Multi Chip Package (MCP), Wafer-level Fabricated Package (WFP), Wafer-Level Processed Stack Package (WSP).

The bi-directional current sensor 1200 of the disclosure described above may be configured to sense current in both the buck mode and the boost mode of the bi-directional DC-DC converter 1000. In particular, the bi-directional current sensor 1200 may sense current using the same element as the (ground-side) power transistor of the DC-DC converter 1000. Accordingly, mismatch between the gate-source voltage and the drain-source voltage of the (ground-side) power transistor and the sensing transistor can be eliminated. In addition, the bi-directional current sensor 1200 can reduce the inflow of noise current from adjacent elements due to a parasitic bipolar junction transistor BJT. The bi-directional current sensor 1200 can reduce noise by connecting the first ground AVSS, which is less affected by noise, in a copy path that copies the current of the bi-directional DC-DC converter 1000. In addition, the bi-directional current sensor 1200 may apply a common mode low pass filter LPF structure to a sensing path for sensing current. That is, it is possible to implement a high common mode rejection ratio CMRR. Thus, the bi-directional current sensor 1200 of the disclosure can provide high noise performance. These advantages of the disclosure will be explained in more detail through the drawings to be described later.

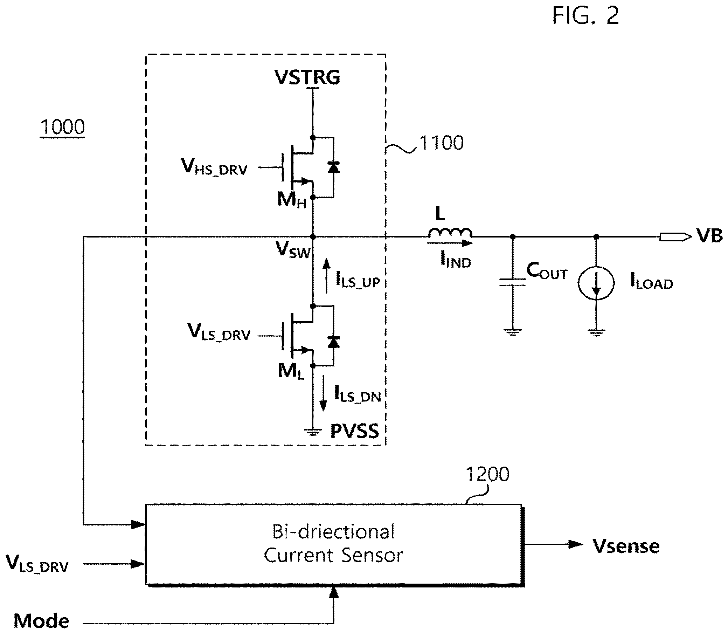

FIG. 2 is a block diagram showing the configuration of a bi-directional DC-DC converter of the disclosure. Referring to FIG. 2, the bi-directional DC-DC converter 1000 includes an inductor L, a switching transistor 1100 for switching current of the inductor L, and the bi-directional current sensor 1200. In one example, the terms "$C_{OUT}$" and "$I_{LOAD}$" refer to the output stage capacitor and load current formed as the PLP IC (110) is connected to the PMIC (120).

The switching transistor 1100 for switching the current of the inductor L may include a first switching transistor $M_H$ and a second switching transistor $M_L$. The first switching transistor $M_H$ is configured to switch the voltage VSTRG to increase the inductor current $I_{IND}$ supplied to the load side through the inductor L. On the other hand, the second switching transistor $M_L$ is configured to switch between one end of the inductor L and the second ground voltage PVSS to reduce the inductor current $I_{IND}$ supplied to the load through the inductor L. The first switching transistor $M_H$ is turned on or turned off by the first driving voltage $V_{HS\_DRV}$. The second switching transistor $M_L$ is controlled by the second driving voltage $V_{LS\_DRV}$ provided to the gate. The first switching transistor $M_H$ and the second switching transistor $M_L$ may be implemented as a Lateral Double Diffused MOS (LDMOS) FET that may be used as a high voltage switching device. In one example, the first and second driving voltages may be referred to as first and second driving signals.

In particular, the direction of the current flowing through the second switching transistor $M_L$ varies according to the operation mode of the bi-directional DC-DC converter 1000. For example, during a normal operation of the bi-directional DC-DC converter 1000 or during the boost mode, the switching node voltage Vsw to which the inductor L is connected becomes a positive voltage. Therefore, in the boost mode, the downward current $I_{LS\_DN}$ flows through the second switching transistor $M_L$. On the other hand, when the input voltage VIN is blocked or a power failure occurs, the bi-directional DC-DC converter 1000 operates in the buck mode to support backup operation using the power charged in the capacitor $C_{PLP}$. At this time, the switching node voltage Vsw is formed as a negative voltage. Accordingly, an upward current $I_{LS\_UP}$ flows through the second switching transistor $M_L$ in the buck mode. In one example, the switching node voltage is at a drain of the second switching transistor.

The bi-directional current sensor 1200 is configured to receive the switching node voltage Vsw, the mode signal 'Mode,' and the second driving voltage $V_{LS\_DRV}$ and is configured to sense the current flowing through the second switching transistor $M_L$. The second driving voltage $V_{LS\_DRV}$ is a control signal applied to the gate of the second switching transistor $M_L$. The bi-directional current sensor 1200 may be configured to sense an upward current $I_{LS\_UP}$ or a downward current $I_{LS\_DN}$ according to (based on) a mode. That is, the single current sensor (bi-directional current sensor 1200) is used for both the boost mode and the buck mode. That is, when the downward current $I_{LS\_DN}$ is formed in the second switching transistor $M_L$ in the boost mode, the bi-directional current sensor 1200 may be configured to copy and sense the downward current $I_{LS\_DN}$ using the switching node voltage Vsw. In the buck mode, the switching node voltage Vsw is formed as a negative voltage by the upward current $I_{LS\_UP}$ flowing through the second switching transistor $M_L$. Even at this time, the bi-directional current sensor 1200 may be configured to copy and sense the upward current $I_{LS\_UP}$ using the negative switching node voltage Vsw. At this time, the magnitude of the sensed current may be output as a sensing voltage $V_{SENSE}$.

In one embodiment, the bi-directional current sensor 1200 may perform an overcurrent protection operation based on the magnitude of the sensed upward current $I_{LS\_UP}$ or downward current $I_{LS\_DN}$. For example, in the boost mode, a peak of the downward current $I_{LS\_DN}$ may be detected by the bi-directional current sensor 1200. Then, the bi-directional DC-DC converter 1000 may perform the overcurrent protection operation by detecting a peak of the downward current $I_{LS\_DN}$. On the other hand, in the buck mode, a valley of the upward current $I_{LS\_DN}$ may be detected by the bi-directional current sensor 1200. Similarly, the bi-directional DC-DC converter 1000 may perform the overcurrent protection operation by detecting a valley of the upward current $I_{LS\_DN}$.

In the above, configurations of the switching transistor 1100 and the bi-directional current sensor 1200 of the disclosure have been described. The bi-directional current sensor 1200 may be configured to sense current in both of the buck mode and the boost mode of the bi-directional DC-DC converter 1000. The structure of the bi-directional current sensor 1200 will be described in more detail through the drawings to be described later.

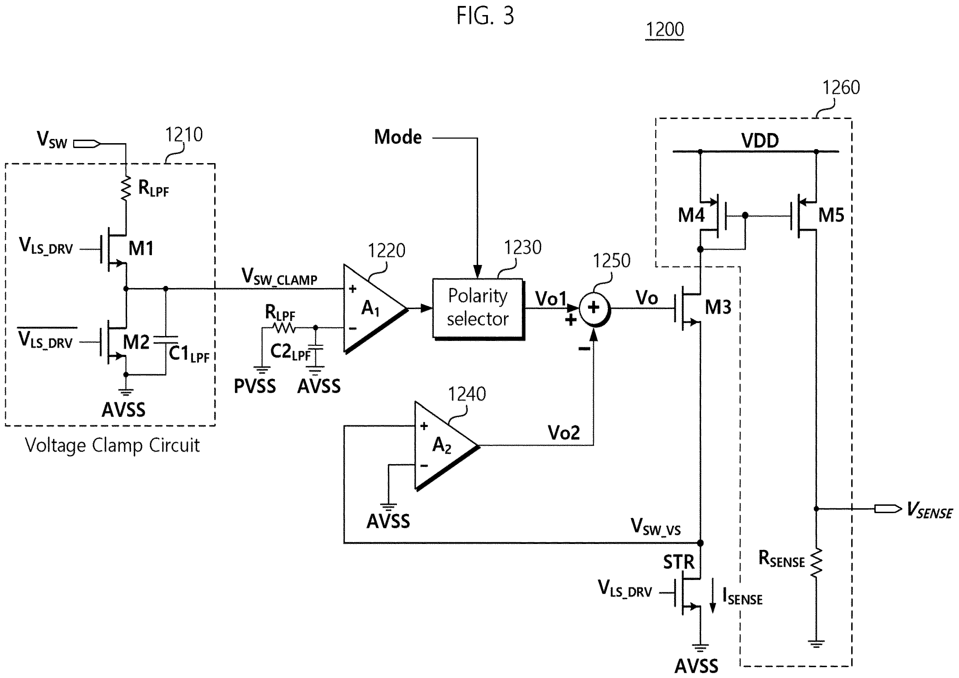

FIG. 3 is a circuit diagram showing an example structure of the bi-directional current sensor 1200 of the disclosure shown in FIG. 2. Referring to FIG. 3, the bi-directional current sensor 1200 includes a voltage clamp circuit 1210, a first amplifier 1220, a polarity selector circuit 1230, a second amplifier 1240, a subtractor circuit 1250, a source follower transistor M3, a sensing transistor STR, and an output circuit 1260.

The voltage clamp circuit 1210 is a circuit for clamping the switching node voltage Vsw of the switching transistor 1100 and for receiving an input to the bi-directional current sensor 1200. The voltage clamp circuit 1210 may include a first transistor M1 and a second transistor M2 and a first capacitor $C1_{LPF}$ serving as a low-pass filter. The first transistor M1 and the second transistor M2 clamp the switching node voltage Vsw by charging the capacitor $C1_{LPF}$ in synchronization with the switching of the second switching transistor $M_L$. That is, the first transistor M1 is controlled by the second driving voltage $V_{LS\_DRV}$, and the second transistor M2 is controlled by the inverted second driving voltage $V_{LS\_DRV}$. When the second driving voltage $V_{LS\_DRV}$ is at a high level, the first transistor M1 is turned on and the second transistor M2 is turned off. Then, the first capacitor $C1_{LPF}$ is charged by the switching node voltage Vsw. On the other hand, when the second driving voltage $V_{LS\_DRV}$ is at a low level, the first transistor M1 is turned off and the second transistor M2 is turned on. Then, charging of the first capacitor $C1_{LPF}$ is stopped and the clamp voltage $V_{SW\_CLAMP}$ is discharged to the ground AVSS. The clamp voltage $V_{SW\_CLAMP}$ in which the switching node voltage Vsw is clamped is transferred to the positive input terminal of the first amplifier 1220. In one example, the first capacitor $C1_{LPF}$ may be referred to as a clamp capacitor.

The first amplifier 1220 and the polarity selector circuit 1230 may provide the positive first amplified voltage Vo1 to the subtractor circuit 1250 regardless of the operation mode of the bi-directional DC-DC converter 1000. For example, when the bi-directional DC-DC converter 1000 operates in the boost mode, the first amplifier 1220 and the polarity selector circuit 1230 may amplify the differential voltage between the voltage input to the positive input terminal (+) and the second ground PVSS with a gain A1 and output a positive output voltage. In the boost mode, the downward current $I_{LS\_DN}$ flows through the second switching transistor $M_L$, and the switching node voltage Vsw and the clamp voltage $V_{SW\_CLAMP}$ are transferred as positive voltages. Accordingly, in the boost mode, the polarity selector circuit 1230 transfers the positive output voltage output from the first amplifier 1220 as the first amplified voltage Vo1 without switching the polarity.

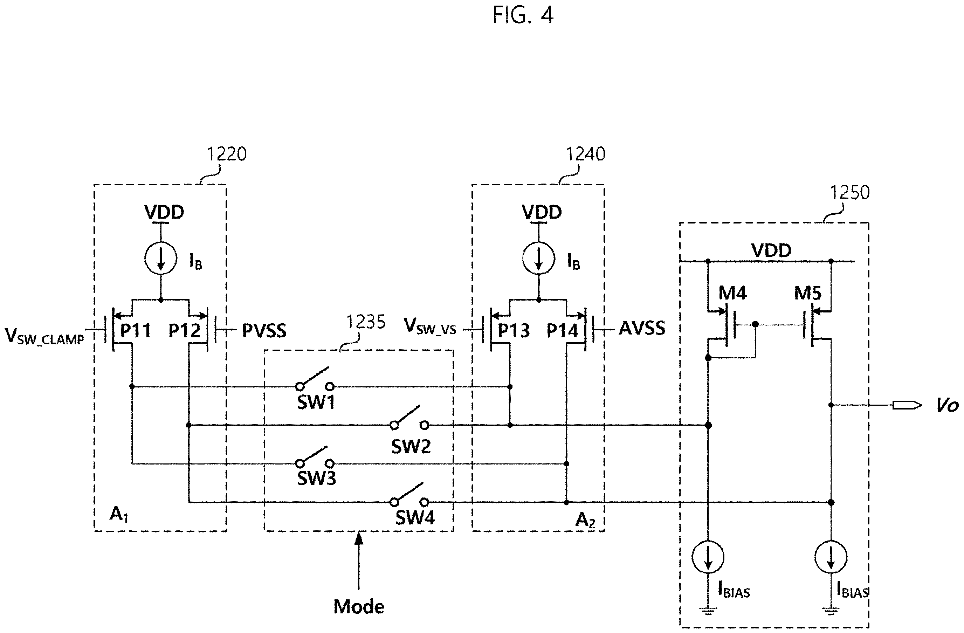

On the other hand, when the bi-directional DC-DC converter 1000 operates in the buck mode, an upward current $I_{LS\_UP}$ flows through the second switching transistor $M_L$. At this time, the switching node voltage Vsw is formed as a negative voltage, which is lower than the second ground voltage PVSS. Accordingly, the voltage clamp circuit 1210 provides the clamp voltage $V_{SW\_CLAMP}$ clamped to the negative switching node voltage Vsw to the positive input terminal of the first amplifier 1220. Then, the first amplifier 1220 amplifies the differential voltage between the negative clamp voltage $V_{SW\_CLAMP}$ and the second ground voltage PVSS by a gain A1. That is, in the buck mode, the first amplifier 1220 amplifies the differential voltage between the clamp voltage $V_{SW\_CLAMP}$ and the second ground PVSS, which is a negative voltage, and outputs a negative voltage amplified voltage. Then, the polarity selector circuit 1230 converts the polarity of the negative voltage output from the first amplifier 1220 to generate the first amplified voltage Vo1, which is a positive voltage. In the buck mode, the negative voltage output from the first amplifier 1220 may be transferred to the subtractor circuit 1250 as a positive first amplified voltage Vo1 by the polarity selector circuit 1230. An example configuration of the first amplifier 1220 will be described in more detail in FIG. 4 described below.

In one embodiment, the second amplifier 1240 amplifies the differential voltage between the virtual voltage $V_{SW\_VS}$ formed at the drain of the sensing transistor STR and the first ground voltage AVSS and outputs the amplified second amplified voltage Vo2. The second amplified voltage Vo2 is provided as a negative feedback voltage of the subtractor circuit 1250. The subtractor circuit 1250 subtracts the second amplified voltage Vo2 from the first amplified voltage Vo1 and outputs the amplified voltage Vo. The amplified voltage Vo is provided as the gate voltage of the source follower transistor M3. That is, the subtractor circuit 1250, the second amplifier 1240, and the source follower transistor M3 may form a negative feedback loop.

If the amplified voltage Vo rises, the virtual voltage Vsw vs corresponding to the source terminal of the source follower transistor M3 or the drain voltage of the sensing transistor STR rises. As the virtual voltage $V_{SW\_VS}$ rises, the second amplifier 1240 increases the second amplification voltage Vo2. Then, the magnitude of the voltage subtracted from the first amplified voltage Vo1 by the subtractor circuit 1250 also increases. As a result, the first amplification voltage Vo1 converges to the same magnitude as the clamp voltage $V_{SW\_CLAMP}$, which is the input voltage of the first amplifier 1220, by the negative feedback loop.

The sensing transistor STR may generate a sensing current $I_{SENSE}$ corresponding to the magnitude of the virtual voltage Vsw vs. The second driving voltage $V_{LS\_DRV}$ may be applied to the gate of the sensing transistor STR. Accordingly, it may be matched to have the same gate-source voltage or drain-source voltage as that of the second switching transistor $M_L$. On the other hand, the sensing transistor STR may be formed with a smaller size than the second switching transistor $M_L$ at a specific (e.g. predetermined) ratio (e.g., 5000: 1). Accordingly, the sensing current $I_{SENSE}$ (that may be generated by the sensing transistor STR) may be generated with 1/5000 the magnitude of the upward current $I_{LS\_UP}$ or the downward current $I_{LS\_DN}$.

The output circuit 1260 operates as a current mirror using transistors M4 and M5. The mirroring current of the sensing current $I_{SENSE}$ flows through the sensing resistor $R_{SENSE}$ of the output circuit 1260. Then, the sensing voltage $V_{SENSE}$ corresponding to the sensing current $I_{SENSE}$ may be output according to (based on) the mode (the boost mode or the buck mode). A current peak or current valley may be detected based on the sensing voltage $V_{SENSE}$, and overcurrent control of the bi-directional DC-DC converter 1000 may be performed.

In the above, the structure of the bi-directional current sensor 1200 of the disclosure has been described. The bi-directional current sensor 1200 may be configured to sense the upward current $I_{LS\_UP}$ or the downward current $I_{LS\_DN}$ regardless of the direction of the sensed current in the boost mode or in the buck mode. This may be possible by the structure of the first amplifier 1220 in which polarity may be selected according to the mode.

FIG. 4 is a diagram showing example structures of a first amplifier, a second amplifier, and a subtractor circuit of FIG. 3. Referring to FIG. 4, a switch unit 1235 (for selecting an amplifier polarity according to a mode) is placed between the first amplifier 1220 and the second amplifier 1240. In one example, the term "$I_{BIAS}$" in FIG. 4 refers to the same bias current source for constructing subtractor 1250.

The first amplifier 1220 includes a current source $I_B$ and p-channel metal-oxide-semiconductor (PMOS) transistors P11 and P12 constituting an input terminal. For example, the clamp voltage $V_{SW\_CLAMP}$ may be applied to the gate of the PMOS transistor P11 as an input signal of a positive input terminal. Also, the second ground voltage PVSS may be provided to the gate of the PMOS transistor P12 as an input signal of the negative input terminal.

The second amplifier 1240 may include a current source $I_B$ and PMOS transistors P13 and P14 constituting an input terminal. For example, the feedbacked virtual voltage Vsw vs may be provided to the gate of the PMOS transistor P13 as an input signal of a positive input terminal. Also, the first ground voltage AVSS may be provided as an input signal of the negative input terminal to the gate of the PMOS transistor P14.

The switch unit 1235 may add or subtract differential current between the first amplifier 1220 and the second amplifier 1240 according to a mode (based on the boost mode or the buck mode). When the bi-directional DC-DC converter 1000 operates in the boost mode, the switches SW1 and SW4 may be turned on, and the switches SW2 and SW3 may be turned off. On the other hand, when the bi-directional DC-DC converter 1000 operates in the buck mode, the switches SW1 and SW4 may be turned off and the switches SW2 and SW3 may be turned on.

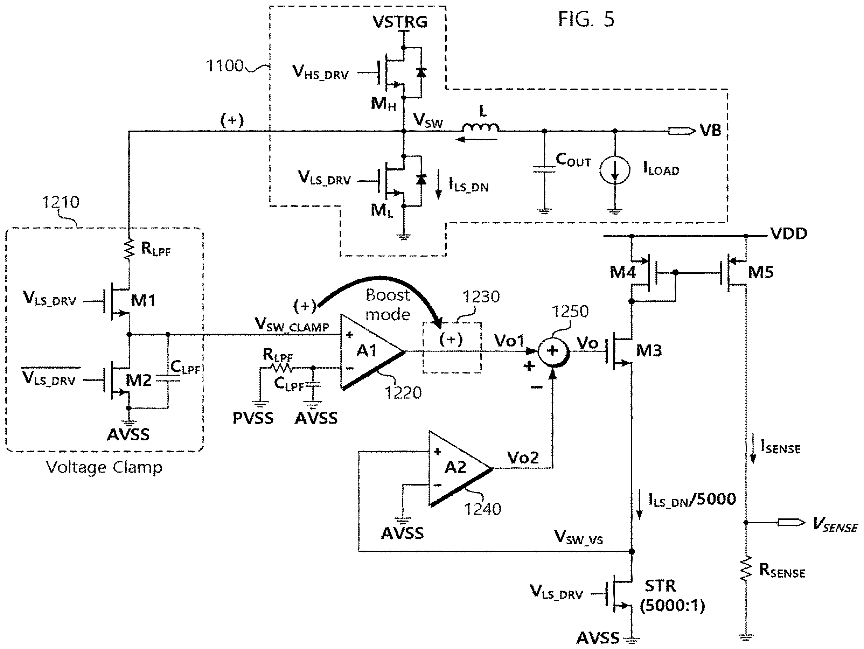

FIG. 5 is a circuit diagram showing the current sensing operation of a bi-directional current sensor 1200 in the boost mode. Referring to FIG. 5, a downward current $I_{LS\_DN}$ flowing toward the ground is generated in the second switching transistor $M_L$ in the boost mode. Therefore, the switching node voltage Vsw appears as a positive voltage.

In one embodiment, the positive switching node voltage Vsw is clamped by the voltage clamp circuit 1210. The clamp voltage $V_{SW\_CLAMP}$ clamped by the voltage clamping circuit 1210 is supplied to the positive input terminal of the first amplifier 1220. The first amplifier 1220 amplifies the differential voltage between the positive clamp voltage $V_{SW\_CLAMP}$ and the second ground voltage PVSS with a first gain A1. As a result, the first amplified voltage Vo1 is output from the first amplifier 1220.

The polarity selector circuit 1230 transfers the output voltage of the positive voltage output from the first amplifier 1220 in the boost mode as the first amplified voltage Vo1 without switching the polarity. Input/output characteristics of the first amplifier 1220 and the polarity selector circuit 1230 in the boost mode can be expressed by Equation 1 below.

[Equation 1]

$$Vo1 = +A1 \times V_{SW\_CLAMP}$$

Here, 'A1' represents the gain of the first amplifier 1220. As a result, the first amplification voltage Vo1 transmitted to the subtractor circuit 1250 has the same polarity as the positive voltage, the clamp voltage $V_{SW\_CLAMP}$.

In one embodiment, the amplified voltage Vo (output from the subtractor circuit 1250) increases the virtual voltage $V_{SW\_VS}$ through the source follower transistor M3. The increased virtual voltage Vsw vs is transferred to the positive input terminal of the second amplifier 1240. Then, the second amplifier 1240 amplifies the differential voltage between the virtual voltage $V_{SW\_VS}$ and the first ground voltage AVSS with the second gain A2 and outputs the amplified voltage as the second amplified voltage Vo2. The subtractor circuit 1250 subtracts the second amplified voltage Vo2 from the first amplified voltage Vo1. That is, the virtual voltage Vsw vs is negatively fed back through a loop formed by the source follower transistor M3, the second amplifier 1240, and the subtractor circuit 1250. Accordingly, in the boost mode, the magnitude of the virtual voltage Vsw vs converges to the clamp voltage $V_{SW\_CLAMP}$ due to a negative feedback.

As a result, a virtual voltage Vsw vs corresponding to the switching node voltage Vsw is formed at both ends of the sensing transistor STR. Similarly to the second switching transistor $M_L$, the sensing current $I_{LS\_DN}$/5000 copied from the downward current $I_{LS\_DN}$ flows to the sensing transistor STR receiving the second driving voltage $V_{LS\_DRV}$ through its gate. Then, the sensing current $I_{LS\_DN}$/5000 flows through the current mirror to the sensing resistor $R_{SENSE}$, and as a result, it can be detected as the sensing voltage $V_{SENSE}$.

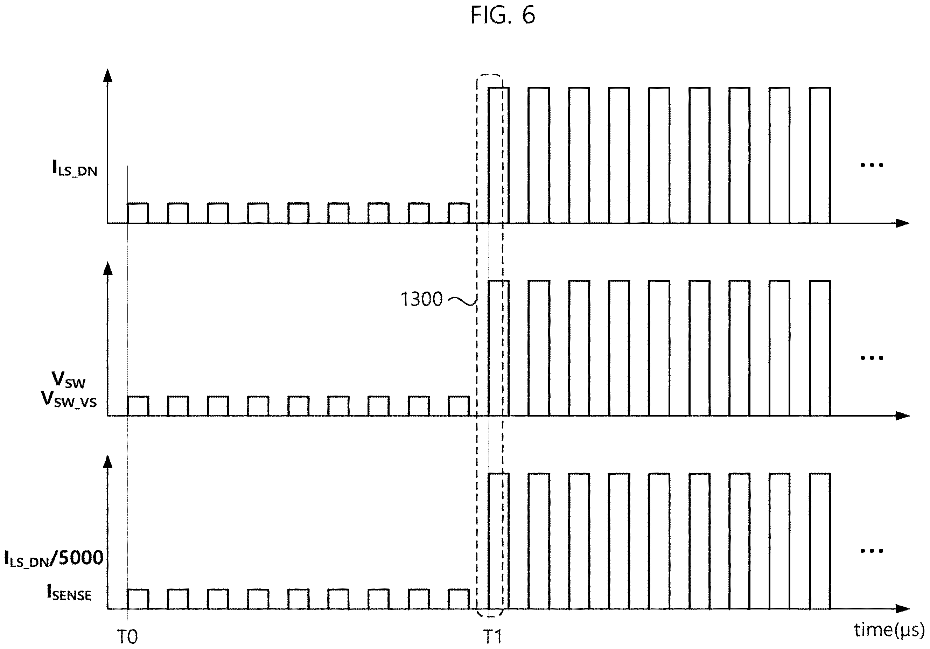

FIG. 6 is a waveform diagram illustrating an operation of the bi-directional current sensor 1200 of FIG. 5. Referring to FIG. 6, a downward current $I_{LS\_DN}$ is generated in the second switching transistor $M_L$ in the boost mode. Also, the bi-directional current sensor 1200 copies the switching node voltage Vsw formed by the downward current $I_{LS\_DN}$ to the virtual voltage $V_{SW\_VS}$. The bi-directional current sensor 1200 may output the sensing current $I_{SENSE}$ or the sensing voltage $V_{SENSE}$ using the virtual voltage Vsw vs.

At time T0, the switching transistor 1100 operates in the boost mode. That is, the second switching transistor $M_L$ repeats a turn-on/turn-off operation by the square wave second driving voltage $V_{LS\_DRV}$. Then, the switching node voltage Vsw is transmitted to the voltage clamp circuit 1210 in the same phase according to the switching state of the second switching transistor $M_L$.

The clamp voltage $V_{SW\_CLAMP}$ clamped in the voltage clamp circuit 1210 is transferred as a virtual voltage Vsw vs by the first amplifier 1220, the polarity selector circuit 1230, the subtractor circuit 1250, the source follower transistor M3, and the second amplifier 1240. Then, the virtual voltage $V_{SW\_VS}$ is copied in the same phase as the switching node voltage Vsw by a virtual short. As a result, the sensing current $I_{SENSE}$ flowing through the sensing transistor STR can be copied with a value reduced by 1/5000 times only the size of the downward current $I_{LS\_DN}$.

At the time point T1, the waveform changes of the downward current $I_{LS\_DN}$, the switching node voltage Vsw, the virtual voltage Vsw vs, and the sensing current $I_{SENSE}$ when the magnitude of the downward current $I_{LS\_DN}$ rapidly increases are shown. Even when the magnitude of the downward current $I_{LS\_DN}$ rapidly increases, the bi-directional current sensor 1200 of the disclosure can generate the sensing current $I_{SENSE}$ that reflects the change in the downward current $I_{LS\_DN}$ with the same phase.

In the above, it has been described that the phase or size of the downward current $I_{LS\_DN}$ may be monitored as the sensing current $I_{SENSE}$ by the bi-directional current sensor 1200 of the disclosure in the boost mode.

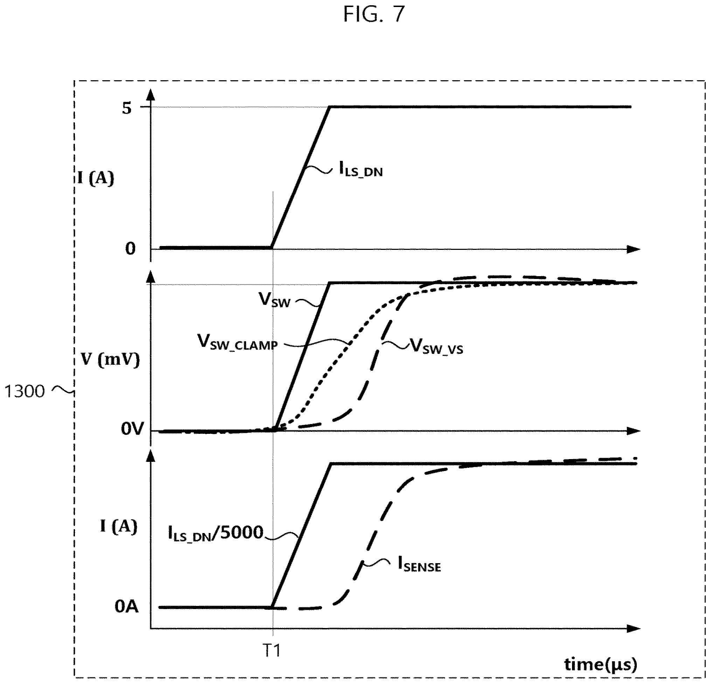

FIG. 7 is a waveform diagram showing waveforms of a section of FIG. 6 in more detail. Referring to FIG. 7, waveforms of voltage or current of the bi-directional current sensor 1200 that vary according to a change in downward current $I_{LS\_DN}$ in a partial section 1300 of FIG. 6 are shown.

At the time T1, the downward current $I_{LS\_DN}$ flowing through the second switching transistor $M_L$ rapidly rises from 0A to 5A. If the magnitude of the downward current $I_{LS\_DN}$ corresponds to the overcurrent, it may be necessary to determine the overcurrent using the sensing current $I_{SENSE}$ or the sensing voltage $V_{SENSE}$ detected by the bi-directional current sensor 1200.

An increase in the downward current $I_{LS\_DN}$ appears as an increase in the switching node voltage Vsw. The switching node voltage Vsw appears as a waveform similar to that of the downward current $I_{LS\_DN}$. Also, the clamp voltage $V_{SW\_CLAMP}$ obtained by clamping the switching node voltage Vsw using the first capacitor $C1_{PLP}$ rises with a relative delay due to the effect of the capacitance. Also, the virtual voltage Vsw vs generated by the first amplifier 1220, the polarity selector circuit 1230, the subtractor circuit 1250, the source follower transistor M3, and the second amplifier 1240 rise to the same phase with the switching node voltage Vsw. As a result, the sensing current $I_{SENSE}$ is generated as the same waveform with the same phase as the virtual voltage Vsw vs.

When the magnitude of the downward current $I_{LS\_DN}$ rapidly increases in the boost mode, the bi-directional current sensor 1200 of the disclosure may generate a sensing current $I_{SENSE}$ that reflects the change in the downward current $I_{LS\_DN}$ with the same phase. The virtual voltage Vsw vs generated by the negative feedback rises in phase with the switching node voltage Vsw. Accordingly, the overcurrent state of the bi-directional DC-DC converter 1000 in the boost mode may be easily detected through the sensing current $I_{SENSE}$ copied in the same phase and the same waveform as the downlink current $I_{LS\_DN}$.

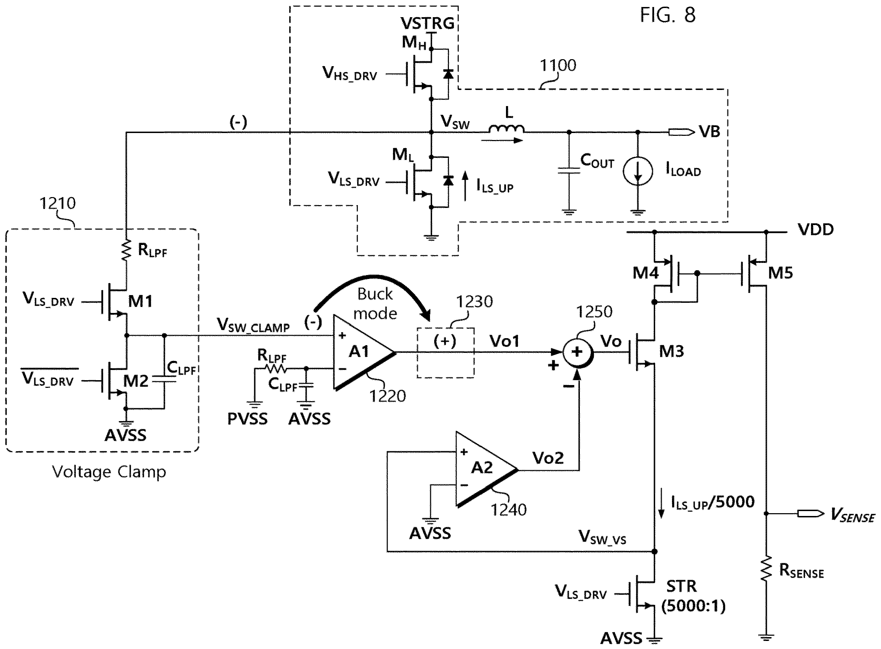

FIG. 8 is a circuit diagram showing a current sensing operation of a bi-directional current sensor 1200 in the buck mode. Referring to FIG. 8, an upward current $I_{LS\_UP}$ flows across the second switching transistor $M_L$ in the buck mode. The upward current $I_{LS\_UP}$ flows from ground to one end of the inductor L. Therefore, the switching node voltage Vsw appears as a negative voltage.

The negative switching node voltage Vsw is clamped by the voltage clamp circuit 1210. The clamp voltage $V_{SW\_CLAMP}$ clamped by the voltage clamping circuit 1210 is supplied to the positive input terminal of the first amplifier 1220. The first amplifier 1220 amplifies the differential voltage between the negative clamp voltage $V_{SW\_CLAMP}$ and the second ground voltage PVSS with a first gain A1 and outputs the amplified voltage. However, in the buck mode, the polarity of the output voltage of the first amplifier 1220 is converted to a positive voltage by the polarity selector circuit 1230 and transmitted as the first amplified voltage Vo1.

Input/output characteristics of the first amplifier 1220 and the polarity selector circuit 1230 in the buck mode can be expressed by Equation 2 below.

[Equation 2]

$$Vo1 = -A1 \times V_{SW\_CLAMP}$$

Here, 'A1' represents the gain of the first amplifier 1220. In the buck mode, the clamp voltage $V_{SW\_CLAMP}$, which is a negative voltage, is amplified with a gain A1 by the first amplifier 1220 and the polarity selector circuit 1230, and the polarity is inverted and transmitted as the first amplified voltage Vo1. As a result, the first amplification voltage Vo1 transmitted to the subtractor circuit 1250 has an inverted polarity of the clamp voltage $V_{SW\_CLAMP}$, which is a negative voltage.

Also, the amplified voltage Vo (output from the subtractor circuit 1250) increases the virtual voltage Vsw vs through the source follower transistor M3. The increased virtual voltage Vsw vs is transferred to the positive input terminal of the second amplifier 1240. Then, the second amplifier 1240 amplifies the differential voltage between the virtual voltage $V_{SW\_VS}$ and the first ground voltage AVSS with the second gain A2 and outputs the amplified voltage as the second amplified voltage Vo2. The subtractor circuit 1250 subtracts the second amplified voltage Vo2 from the first amplified voltage Vo1. That is, the virtual voltage Vsw vs is negatively fed back through a loop formed by the source follower transistor M3, the second amplifier 1240, and the subtractor circuit 1250. Therefore, even in the buck mode, the magnitude of the virtual voltage Vsw vs converges to the inverted clamp voltage $V_{SW\_CLAMP}$ due to a negative feedback.

As a result, a positive virtual voltage Vsw vs corresponding to the negative switching node voltage Vsw is formed at the drain terminal of the sensing transistor STR. Similarly to the second switching transistor $M_L$, the sensing current $I_{LS\_UP}/5000$ copied from the upward current $I_{LS\_UP}$ flows to the sensing transistor STR receiving the second driving voltage $V_{LS\_DRV}$ through its gate. Then, the sensing current $I_{LS\_UP}/5000$ flows through the current mirror to the sensing resistor $R_{SENSE}$, and as a result, the sensing voltage $V_{SENSE}$ can be output.

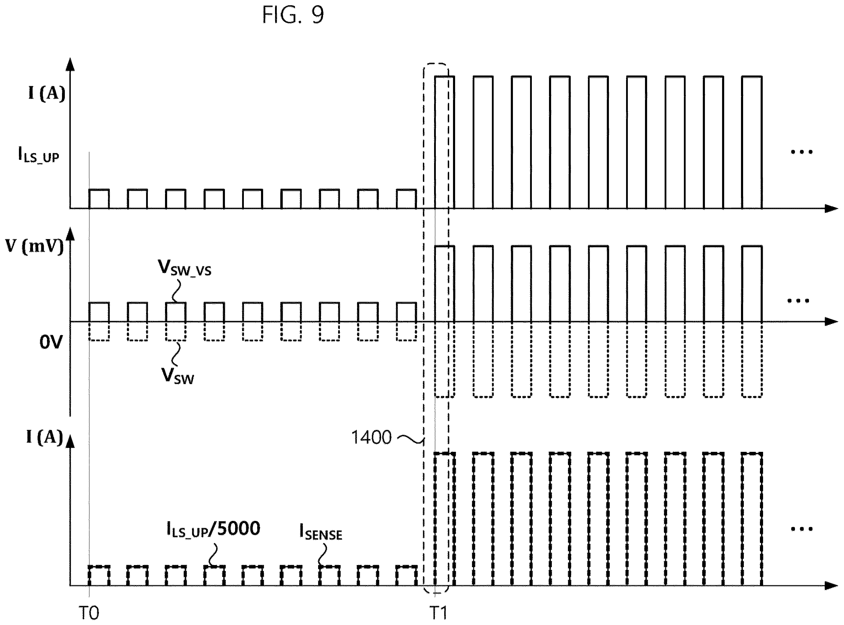

FIG. 9 is a waveform diagram illustrating an operation of the bi-directional current sensor 1200 of FIG. 8. Referring to FIG. 9, in the buck mode, an upward current $I_{LS\_UP}$ flows through the second switching transistor $M_L$, and the bi-directional current sensor 1200 copies the negative switching node voltage Vsw as a virtual voltage $V_{SW\_VS}$. Also, the bi-directional current sensor 1200 may generate the sensing current $I_{SENSE}$ or the sensing voltage $V_{SENSE}$ generated through the virtual voltage Vsw vs.

At time T0, the switching transistor 1100 operates in the buck mode. That is, the second switching transistor $M_L$ repeats a turn-on/turn-off operation by the square wave second driving voltage $V_{LS\_DRV}$. At this time, an upward current $I_{LS\_UP}$ flows from the ground to the switching node in the form of a square wave. Then, the negative switching node voltage Vsw is clamped by the voltage clamp circuit 1210. The clamp voltage $V_{SW\_CLAMP}$ clamped by the voltage clamp circuit 1210 is transmitted to the first amplifier 1220. The polarity of the output voltage of the first amplifier 1220 is converted by the polarity selector circuit 1230 and transmitted to the subtractor circuit 1250 as a positive first amplified voltage Vo1. Then, the virtual voltage Vsw vs is generated in the negative feedback loop formed by the subtractor circuit 1250, the source follower transistor M3, and the second amplifier 1240. Due to the virtual short, the virtual voltage Vsw vs is generated in the form of an inverted switching node voltage Vsw, which is a negative voltage. As a result, the sensing current $I_{SENSE}$ flowing through the sensing transistor STR can be copied with a value reduced by 1/5000 times the upward current $I_{LS\_UP}$.

At the time point T1, the waveform changes of the upward current $I_{LS\_UP}$, the switching node voltage Vsw, the virtual voltage Vsw vs, and the sensing current $I_{SENSE}$ when the magnitude of the upward current $I_{LS\_UP}$ rapidly increases are shown. Even when the magnitude of the upward current $I_{LS\_UP}$ rapidly increases, the bi-directional current sensor 1200 of the disclosure can generate the sensing current $I_{SENSE}$ reflecting the change in the upward current $I_{LS\_UP}$.

In the above, it has been described that the bi-directional current sensor 1200 of the disclosure may monitor the magnitude of the upward current $I_{LS\_UP}$ in the buck mode.

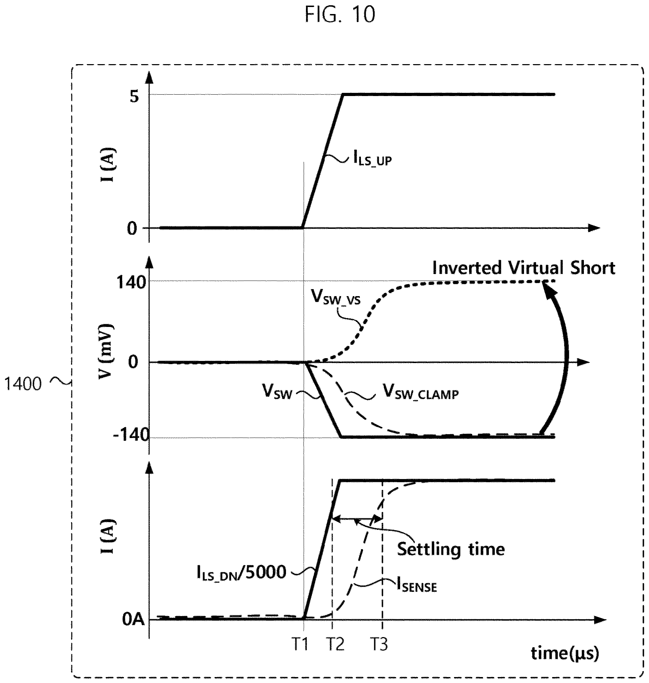

FIG. 10 is a waveform diagram showing waveforms of a partial section of FIG. 9 in more detail. Referring to FIG. 10, waveforms of voltage or current of the bi-directional current sensor 1200 that vary according to the change of the upward current $I_{LS\_UP}$ in the section 1400 of FIG. 9 are shown.

At the time T1, the upward current $I_{LS\_UP}$ flowing through the second switching transistor $M_L$ rapidly rises from 0A to 5A. If the magnitude of the upward current $I_{LS\_UP}$ corresponds to the overcurrent, it may be necessary to determine the overcurrent using the sensing current $I_{SENSE}$ or the sensing voltage $V_{SENSE}$ detected by the bi-directional current sensor 1200.

A change in the upward current $I_{LS\_UP}$ appears as a decrease in the switching node voltage Vsw. That is, as the upward current $I_{LS\_UP}$ increases, the switching node voltage Vsw, which is a negative voltage, decreases. The clamp voltage $V_{SW\_CLAMP}$ clamping the switching node voltage Vsw is formed in a delayed form compared to the switching node voltage Vsw. The clamp voltage $V_{SW\_CLAMP}$ is amplified to a positive voltage whose polarity is switched by the first amplifier 1220 and the polarity selector circuit 1230 in the buck mode. Also, the virtual voltage Vsw vs generated by the negative feedback by the subtractor circuit 1250, the source follower transistor M3, and the second amplifier 1240 has an opposite polarity to the switching node voltage Vsw and increases. As a result, the sensing current $I_{SENSE}$ is generated in the same waveform with the same phase as the virtual voltage Vsw vs.

When the magnitude of the upward current $I_{LS\_UP}$ rapidly increases in the buck mode, the bi-directional current sensor 1200 of the disclosure may generate a sensing current $I_{SENSE}$ that reflects the change in the upward current $I_{LS\_UP}$ with the same phase. The virtual voltage Vsw vs generated by the negative feedback rises in phase with the switching node voltage Vsw. Therefore, the overcurrent state of the bi-directional DC-DC converter 1000 in the buck mode can be easily detected through the sensing current $I_{SENSE}$ copied in the same phase and the same waveform as the upward current $I_{LS\_UP}$.

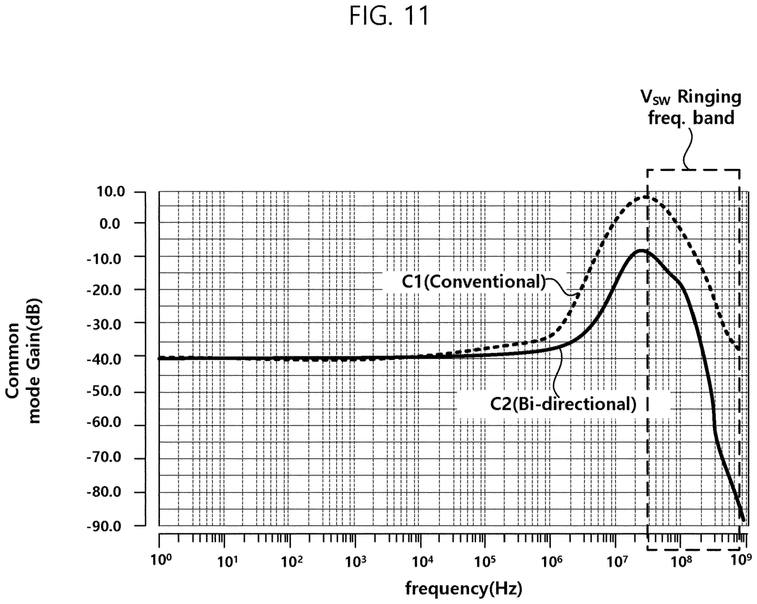

FIG. 11 shows a common mode gain of the bi-directional current sensor 1200 of the disclosure. The common mode gain represents the gain of the second ground voltage PVSS at the sensing node. That is, the common mode gain means the performance of canceling noise introduced into the second ground voltage PVSS node.

Referring to FIG. 11, in the bi-directional current sensor 1200 of the disclosure, a first ground voltage AVSS resistant to noise may be connected to the ground of the sensing transistor STR. Therefore, the bi-directional current sensor 1200 may remove noise introduced into the current copy path. In addition, since the input impedance of the first amplifier 1220 may be implemented as an infinite input impedance (common source type), noise may be reduced through a common mode low-pass filter.

According to the common mode gain curve C2 of the disclosure, the common mode gain shows noise rejection performance of 10 dB or more in the '1 MHz to 30 MHz' band and 20 dB or more in the '30 MHz to 300 MHz' band, compared to the general (conventional) case C1. And, the common mode gain curve C2 exhibits excellent noise cancellation performance of 40 dB or more in a band of 300 MHz or higher. That is, a relatively very low gain may be provided in the ringing frequency band of the switching node voltage Vsw compared to the general case C1. Accordingly, the bi-directional current sensor 1200 of the disclosure can provide relatively high noise removal performance.

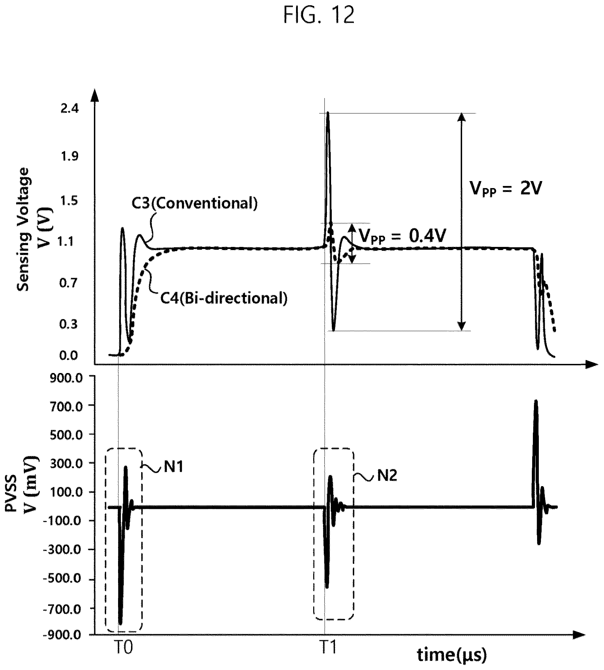

FIG. 12 shows transient response characteristics of the bi-directional current sensor 1200 of the disclosure. Referring to FIG. 12, a change in the sensing voltage $V_{SENSE}$ when noise (i.e., PVSS Noise) due to an adjacent channel may be introduced during operation of the bi-directional current sensor 1200 is shown.

First, the response of the sensing voltage $V_{SENSE}$ to the noise N1 generated by itself at the time point T0 is shown. The sensing voltage $V_{SENSE}$ when the technique of the disclosure is applied is represented by a curve C4. In the current sensors in the general (conventional) case C3 to which the technology of the disclosure is not applied, the sensing voltage $V_{SENSE}$ fluctuates unstably because noise is not removed. On the other hand, in the case of the bi-directional current sensor 1200 of the disclosure, the sensing voltage $V_{SENSE}$ stably increases without ringing.

At the time point T1, the response of the sensing voltage $V_{SENSE}$ to the noise N2 introduced from the adjacent channel is shown. In this case, the peak-to-peak difference $V_{PP}$ of the waveform of the sensing voltage $V_{SENSE}$ appearing in the bi-directional current sensor 1200 of the disclosure is slightly generated at about 0.4V. On the other hand, in the current sensor of the general case C3 to which the technology of the disclosure is not applied, the incoming noise is not removed, so the peak-to-peak difference $V_{PP}$ between the peaks of the sensing voltage $V_{SENSE}$ appears to be about 2V.

As described above, in the case of the bi-directional current sensor 1200 of the disclosure, high noise performance may be provided against noise generated by itself or incoming noise from an adjacent channel.

Embodiments are set out in the following clauses:

Clause 1.A bi-directional direct current to direct current (DC-DC) converter comprising: an inductor; a first switching transistor configured to switch a power supply voltage to one end of the inductor, in response to a first driving signal; a second switching transistor configured to switch between one end of the inductor and a ground voltage, in response to a second driving signal; and a bi-directional current sensor configured to sense a bi-directional current flowing through the second switching transistor in a boost mode and a buck mode, based on a switching node voltage at a drain of the second switching transistor, wherein the bi-directional current sensor is further configured to generate a virtual voltage of a positive voltage in a negative feedback method regardless of the sign of the switching node voltage to copy the bi-directional current.

Clause 2. The bi-directional DC-DC converter of clause 1, wherein the bi-directional current sensor comprises: a voltage clamp circuit configured to generate a clamp voltage by clamping the switching node voltage; a first amplifier configured to generate a first amplified voltage by amplifying a differential voltage between the clamp voltage and the ground voltage; a polarity selector circuit configured to convert a polarity of the first amplified voltage into a positive voltage, based on the boost mode or the buck mode; a second amplifier configured to amplify the differential voltage between the virtual voltage and the ground voltage and to generate a second amplified voltage; a subtractor circuit configured to generate an amplified voltage by subtracting the second amplified voltage from the first amplified voltage; a source follower transistor configured to transmit the amplified voltage to the virtual voltage; and a sensing transistor configured to generate a sensing current corresponding to the virtual voltage.

Clause 3. The bi-directional DC-DC converter of clause 2, wherein the voltage clamp circuit comprises: a clamp capacitor; a first transistor configured to transmit the switching node voltage to the clamp capacitor, in response to the second driving signal; and a second transistor configured to discharge the clamp capacitor to a ground, in response to the second driving signal.

Clause 4. The bi-directional DC-DC converter of clause 2 or 3, wherein the first amplifier is configured to receive the clamp voltage as a positive input terminal and the ground voltage as a negative input terminal and to output the first amplified voltage; and wherein the polarity selector circuit is configured to convert the first amplified voltage of a negative voltage into a positive voltage in the buck mode.

Clause 5. The bi-directional DC-DC converter of clause 4, wherein the polarity selector circuit is configured to transmit the first amplified voltage of a positive voltage to the subtractor circuit without polarity conversion in the boost mode.

Clause 6. The bi-directional DC-DC converter of clause 4 or 5, wherein the sensing transistor is matched to a gate-source voltage and a drain-source voltage of the second switching transistor.

Clause 7. The bi-directional DC-DC converter of claim 6, wherein a size of the sensing transistor is smaller than a size of the second switching transistor at a predetermined ratio.

Clause 8. The bi-directional DC-DC converter of any preceding clause, further comprising an output circuit configured to mirror the sensing current and to provide it as a sensing output.

Clause 9. A bi-directional current sensor for sensing a current flowing in a switching transistor of a direct current to direct current (DC-DC) converter, the bi-directional current sensor comprising: a voltage clamp circuit configured to clamp a switching node voltage at one end of the switching transistor to a clamp voltage; a first amplifier configured to generate a first amplified voltage by amplifying a differential voltage between a clamp voltage and a ground voltage; a polarity selector circuit configured to convert a polarity of the first amplified voltage into a positive voltage, based on a mode; a second amplifier configured to amplify a differential voltage between a virtual voltage and the ground voltage and to generate a second amplified voltage; a subtractor circuit configured to generate an amplified voltage by subtracting the second amplified voltage from the first amplified voltage; a source follower transistor configured to transfer the amplified voltage to the virtual voltage; and a sensing transistor configured to transfer a sensing current corresponding to the virtual voltage to a ground.

Clause 10. The bi-directional current sensor of clause 9, wherein the switching node voltage is generated as a negative voltage in a buck mode and as a positive voltage in a boost mode.

Clause 11. The bi-directional current sensor of clause 9 or 10, wherein the voltage clamp circuit comprises: a clamp capacitor; a first transistor configured to transfer the switching node voltage to the clamp capacitor; and a second transistor configured to discharge the clamp capacitor to the ground.

Clause 12. The bi-directional current sensor of clause 11, wherein a gate voltage of the first transistor is synchronized with a driving signal of the switching transistor.

Clause 13. The bi-directional current sensor of clause 12, wherein a gate voltage of the second transistor is synchronized with an inverted driving signal.

Clause 14. A current sensing method of a switching transistor of a bi-directional DC-DC converter, the current sensing method comprising: generating a clamp voltage by clamping a switching node voltage at one end of the switching transistor; generating a first amplified voltage by amplifying a differential voltage between the clamp voltage and a ground voltage using a first amplifier; generating a second amplified voltage by amplifying a differential voltage between a virtual voltage and the ground voltage using a second amplifier; generating an amplified voltage by subtracting the second amplified voltage from the first amplified voltage; transferring the amplified voltage as the virtual voltage to a sensing transistor through a source follower; and detecting a sensing current flowing through the sensing transistor by the virtual voltage.

Clause 15. The method of clause 14, further comprising converting a polarity of the first amplified voltage output as a negative voltage to generate the first amplified voltage as a positive voltage based on the DC-DC converter that operates in a buck mode.

The above are specific embodiments for carrying out the disclosure. In addition to the above-described embodiments (e.g. FIGs 1 to 12), the disclosure may include simple design changes or easily changeable embodiments. In addition, the disclosure will include techniques that can be easily modified and implemented using the embodiments. Therefore, the scope of the disclosure should not be limited to the above-described embodiments, and should be defined by the claims.

## Claims

1. A bi-directional direct current to direct current (DC-DC) converter comprising:

   an inductor;
   a first switching transistor configured to switch a power supply voltage to one end of the inductor, in response to a first driving signal;
   a second switching transistor configured to switch between one end of the inductor and a ground voltage, in response to a second driving signal; and
   a bi-directional current sensor configured to sense a bi-directional current flowing through the second switching transistor in a boost mode and a buck mode, based on a switching node voltage at a drain of the second switching transistor,
   wherein the bi-directional current sensor is further configured to generate a virtual voltage of a positive voltage in a negative feedback method regardless of the sign of the switching node voltage to copy the bi-directional current.

2. The bi-directional DC-DC converter of claim 1, wherein the bi-directional current sensor comprises:

   a voltage clamp circuit configured to generate a clamp voltage by clamping the switching node voltage;
   a first amplifier configured to generate a first amplified voltage by amplifying a differential voltage between the clamp voltage and the ground voltage;
   a polarity selector circuit configured to convert a polarity of the first amplified voltage into a positive voltage, based on the boost mode or the buck mode;
   a second amplifier configured to amplify the differential voltage between the virtual voltage and the ground voltage and to generate a second amplified voltage;
   a subtractor circuit configured to generate an amplified voltage by subtracting the second amplified voltage from the first amplified voltage;
   a source follower transistor configured to transmit the amplified voltage to the virtual voltage; and
   a sensing transistor configured to generate a sensing current corresponding to the virtual voltage.

3. The bi-directional DC-DC converter of claim 2, wherein the voltage clamp circuit comprises:

   a clamp capacitor;
   a first transistor configured to transmit the switching node voltage to the clamp capacitor, in response to the second driving signal; and
   a second transistor configured to discharge the clamp capacitor to a ground, in response to the second driving signal.

4. The bi-directional DC-DC converter of claim 2 or 3, wherein the first amplifier is configured to receive the clamp voltage as a positive input terminal and the ground voltage as a negative input terminal and to output the first amplified voltage; and
wherein the polarity selector circuit is configured to convert the first amplified voltage of a negative voltage into a positive voltage in the buck mode.

5. The bi-directional DC-DC converter of claim 4, wherein the polarity selector circuit is configured to transmit the first amplified voltage of a positive voltage to the subtractor circuit without polarity conversion in the boost mode.

6. The bi-directional DC-DC converter of claim 4 or 5, wherein the sensing transistor is matched to a gate-source voltage and a drain-source voltage of the second switching transistor.

7. The bi-directional DC-DC converter of claim 6, wherein a size of the sensing transistor is smaller than a size of the second switching transistor at a predetermined ratio.

8. The bi-directional DC-DC converter of any preceding claim, further comprising an output circuit configured to mirror the sensing current and to provide it as a sensing output.

9. A bi-directional current sensor for sensing a current flowing in a switching transistor of a direct current to direct current (DC-DC) converter, the bi-directional current sensor comprising:

a voltage clamp circuit configured to clamp a switching node voltage at one end of the switching transistor to a clamp voltage;
a first amplifier configured to generate a first amplified voltage by amplifying a differential voltage between a clamp voltage and a ground voltage;
a polarity selector circuit configured to convert a polarity of the first amplified voltage into a positive voltage, based on a mode;
a second amplifier configured to amplify a differential voltage between a virtual voltage and the ground voltage and to generate a second amplified voltage;
a subtractor circuit configured to generate an amplified voltage by subtracting the second amplified voltage from the first amplified voltage;
a source follower transistor configured to transfer the amplified voltage to the virtual voltage; and
a sensing transistor configured to transfer a sensing current corresponding to the virtual voltage to a ground.

10. The bi-directional current sensor of claim 9, wherein the switching node voltage is generated as a negative voltage in a buck mode and as a positive voltage in a boost mode.

11. The bi-directional current sensor of claim 9 or 10, wherein the voltage clamp circuit comprises:

a clamp capacitor;
a first transistor configured to transfer the switching node voltage to the clamp capacitor; and
a second transistor configured to discharge the clamp capacitor to the ground.

12. The bi-directional current sensor of claim 11, wherein a gate voltage of the first transistor is synchronized with a driving signal of the switching transistor.

13. The bi-directional current sensor of claim 12, wherein a gate voltage of the second transistor is synchronized with an inverted driving signal.

14. A current sensing method of a switching transistor of a bi-directional DC-DC converter, the current sensing method comprising:

generating a clamp voltage by clamping a switching node voltage at one end of the switching transistor;
generating a first amplified voltage by amplifying a differential voltage between the clamp voltage and a ground voltage using a first amplifier;
generating a second amplified voltage by amplifying a differential voltage between a virtual voltage and the ground voltage using a second amplifier;
generating an amplified voltage by subtracting the second amplified voltage from the first amplified voltage;

transferring the amplified voltage as the virtual voltage to a sensing transistor through a source follower; and detecting a sensing current flowing through the sensing transistor by the virtual voltage.

15. The method of claim 14, further comprising converting a polarity of the first amplified voltage output as a negative voltage to generate the first amplified voltage as a positive voltage based on the DC-DC converter that operates in a buck mode.

# FIG. 1

100

110

PLP IC

1000

Bi-directional
DC-DC converter

VIN

VB

1200

Bi-directional
Current Sensor

$C_{PLP}$

120

PMIC

NAND
(130)

DRAM
(140)

SSD controller
(150)

EP 4 451 531 A1

FIG. 2

FIG. 3

EP 4 451 531 A1

FIG. 4

FIG. 5

FIG. 6

$I_{LS\_DN}$

$V_{SW}$
$V_{SW\_VS}$

1300 ~

$I_{LS\_DN}/5000$

$I_{SENSE}$

T0

T1

time(μs)

EP 4 451 531 A1

FIG. 7

EP 4 451 531 A1

FIG. 8

FIG. 9

EP 4 451 531 A1

FIG. 10

EP 4 451 531 A1

FIG. 11

FIG. 12

EP 4 451 531 A1

Europäisches
Patentamt

European
Patent Office

Office européen
des brevets

# EUROPEAN SEARCH REPORT

Application Number

EP 24 16 6523

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2014/253089 A1 (QIN SONG [CN]) 11 September 2014 (2014-09-11) * figure 5 * | 1-15 | INV. H02M1/00 H02M3/158 |
| X | US 2020/333379 A1 (YAO KAIWEI [US]) 22 October 2020 (2020-10-22) * figure 4 * | 1 | |
| A | US 2005/189981 A1 (MATSUNAGA SHINICHIRO [JP]) 1 September 2005 (2005-09-01) * figure 4 * | 1-15 | |
| A | PATEL A M ET AL: "Advanced Current Sensing Techniques for Power Electronic Converters", VEHICLE POWER AND PROPULSION CONFERENCE, 2007. VPPC 2007. IEEE, IEEE, PISCATAWAY, NJ, USA, 9 September 2007 (2007-09-09), pages 524-530, XP031273630, ISBN: 978-0-7803-9760-6 * figure 6 * * paragraph [II.C] * | 1 | TECHNICAL FIELDS SEARCHED (IPC) H02M G01R |

The present search report has been drawn up for all claims

| Place of search | Date of completion of the search | Examiner |
|---|---|---|
| The Hague | 16 September 2024 | Gotzig, Bernhard |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 24 16 6523

This annex lists the patent family members relating to the patent documents cited in the above-mentioned European search report.
The members are as contained in the European Patent Office EDP file on
The European Patent Office is in no way liable for these particulars which are merely given for the purpose of information.

16-09-2024

| Patent document cited in search report | Publication date | Patent family member(s) | Publication date |
|---|---|---|---|
| US 2014253089 A1 | 11-09-2014 | NONE | |
| US 2020333379 A1 | 22-10-2020 | CN 110261661 A | 20-09-2019 |
| | | US 2020333379 A1 | 22-10-2020 |
| US 2005189981 A1 | 01-09-2005 | JP 4288590 B2 | 01-07-2009 |
| | | JP 2005164381 A | 23-06-2005 |
| | | US 2005189981 A1 | 01-09-2005 |

EPO FORM P0459

For more details about this annex : see Official Journal of the European Patent Office, No. 12/82